Europäisches Patentamt

European Patent Office

Office européen des brevets

(11) Publication number: **0 196 636**
A2

## EUROPEAN PATENT APPLICATION

(21) Application number: **86104294.3**

(22) Date of filing: **27.03.86**

(51) Int. Cl.⁴: **G 09 B 23/18**

(30) Priority: **01.04.85 CN 85102787**

(43) Date of publication of application:
**08.10.86 Bulletin 86/41**

(84) Designated Contracting States:
**BE CH DE FR GB IT LI**

(71) Applicant: **Shanghai Second Polytechnic University**
**80 Shan-xi North Road**
**Shanghai(CN)**

(72) Inventor: **Wei-qin, Guo**
**No. 11, Lone 389 Jin-ling East Road**
**Shanghai(CN)**

(74) Representative: **Kirschner, Klaus Dieter et al,**
**Patentanwälte Kirschner & Grosse**
**Herzog-Wilhelm-Strasse 17**
**D-8000 München 2(DE)**

(54) A teaching and demonstrating apparatus for electrical circuits.

(57) A teaching and demonstrating apparatus for electrical circuits is provided with plug/socket units and circuit-cards and used as kind of training device for experimental and educational purposes in the fields of electricity and electronics. The apparatus is composed of a common jack panel, a set of plug/socket units and a set of circuit-cards. By changing the cards, more than a hundred different circuits can be formed. Each of the circuit-cards has an experimental circuit diagram and all the component symbols printed on it. The symbols are accompanied with apertures in alignment with apertures on the jack panel having female sockets to hold the plug/socket units. The whole electric connection work is accomplished by laying an appropriate circuit-card on the jack panel and plugging all the plug/socket units required into their corresponding apertures in the circuit-card.

Fig: 1a

Fig: 1b

Croydon Printing Company Ltd.

EP 0 196 636 A2

A Teaching and Demonstrating Apparatus for Electrical Circuits


The present invention relates to a teaching and demonstrating apparatus for electrical circuits, in particular to an apparatus which can be used for demonstrating and teaching the composition and function of a large number of electrical and electronical circuits, the various components thereof and their interactions.

Such teaching and demonstrating apparatus for electrical circuits is known for the use with modules (components and plug-in units) on jack panels for forming different circuits. The components may also be directly plugged into female sockets on a jack panel for performing experiments for training. The connection between the components or the modules in such known apparatus are made by switchboard wires (plugged in as needed), short-circuit plugs and rigid connectors. Such connections can be made permanent by soldering and made changable by plugging in and out the connections. Examples of this state of art are: US patent 4,112,593, German disclosure letter 23 27 323, German disclosure letter 21 44 688, German disclosure letter 29 39 083, Japanese publication letter 58-174985, USSR invention No. su-875446 and the US experimental apparatus consisting of Model ET-2100A Breadboard. However, none of the above-mentioned apparatus simultaneously show the required simplicity of construction, convenience of operation and possibility to compose electrical circuits by intuition.

In view of the above, the object of the invention is to provide a teaching and demonstrating apparatus for electrical circuits having - with respect to the state of art - a simplified construction, more convenience in operation and allowing the composition of electrical circuits by intuition.

This object is solved according to the invention as claimed in claim 1.

A preferred embodiment of the invention is comprised of a common jack panel, a set of plug/socket units and a set of circuit-cards, where the jack panel comprises a printed board having various conductive paths, each of the circuit-cards having printed thereon an experimental circuit, and all elements and components shown in the circuit-cards are accompanied with apertures which are in alignment with the apertures of the jack panel which in turn are provided for holding the prongs of the plugged-in elements and/or components whereby electrical connections between the prongs of the plugged-in units and the conductive paths of said printed boards are formed. The complete electrical circuit including the connections between the elements and components can be accomplished by simply laying an appropriate circuit-card on the jack panel and plugging in all the required plug/socket units into the appropriate apertures shown on the circuit-card. Thereby, experiments with such circuit can be started promptly. No soldering, wiring or switching is needed.

Further embodiments and advantages of the invention can be taken from the following description of the embodiments when read in connection with the drawings. In the drawings:

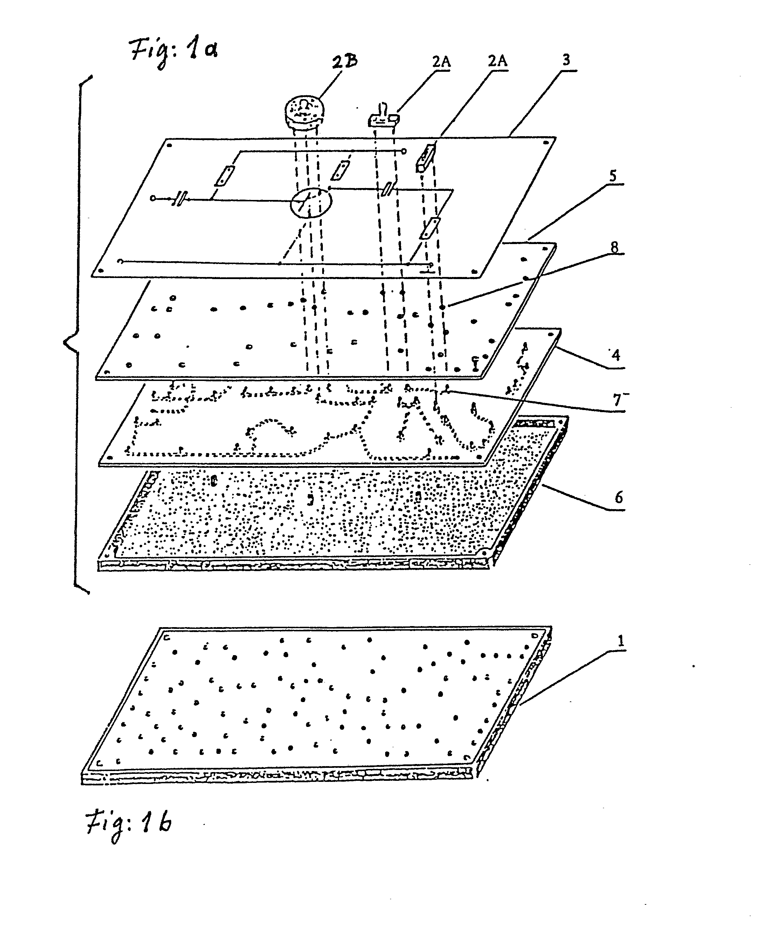

Fig. 1a    shows an exploded view of the apparatus with plug/ socket units, circuit-card and jack panel;

Fig. 1b    shows the assembled jack panel;

Figs. 2-7     show examples of electrical circuits as printed on circuit-cards;

Fig. 8     shows an example of a printed board with the conductive paths printed thereon;

Fig. 9     shows a female socket before and after its assembly with the jack panel;

Fig. 10a     shows a plug unit having two prongs, the unit being shown in side elevation and partly in section;

Fig. 10b     shows a top plan view on the unit of Fig. 10a as plugged into the jack panel;

Fig. 11a     shows a plastic body as a part of a unit;

Fig. 11b     shows a section of Fig. 11a along the line V-V;

Fig. 11c     shows a plan view from the bottom of the plastic body of Fig. 11a including a plastic snap piece;

Fig. 12a     shows a side elevation of a prong used in the plastic body of Fig. 11a;

Fig. 12b     shows another side elevation of the prong of Fig. 12a;

Fig. 13a     shows a side elevation of the plastic snap piece;

Fig. 13b     shows an end elevation of the snap piece of Fig. 13a;

Fig. 13c     shows a bottom elevation of the snap piece of Fig. 13a;

Fig. 14a     shows a plug unit having three prongs, the unit
             being shown in sied elevation and partly in sec-
             tion; and

Fig. 14b     shows a plan view on the unit of Fig. 14a.

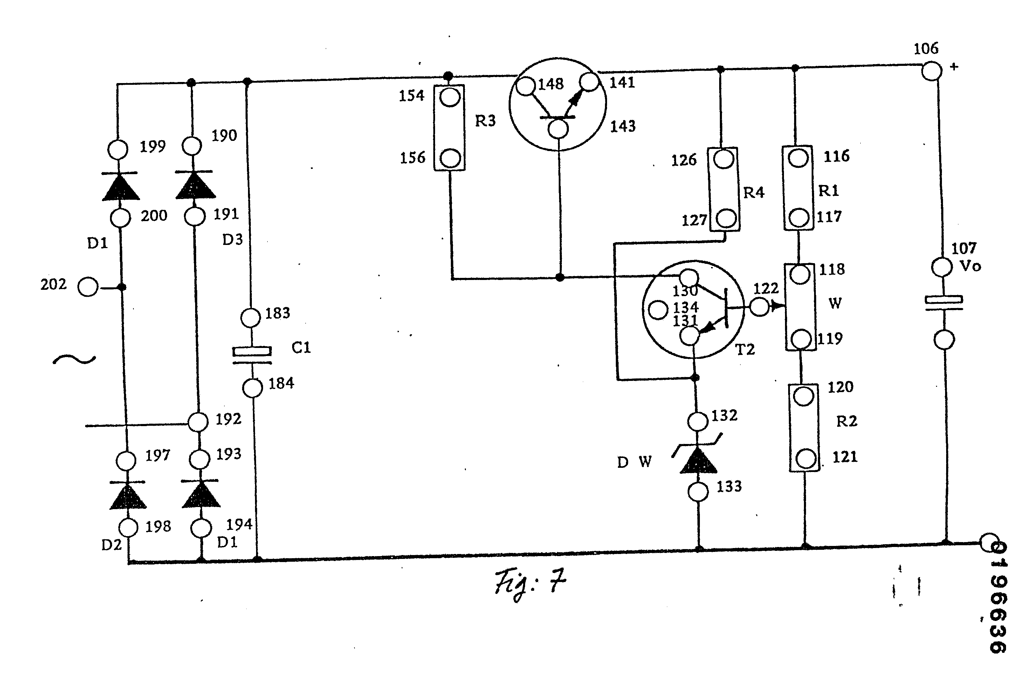

The teaching and demonstrating apparatus for electrical circuits is composed of a jack panel 1, a set of plug/socket
units 2 and a set of circuit-cards 3, the jack panel 1 being
common to a plurality of circuit-cards. The jack panel 1 is
composed of a printed board 4, a face board 5 and a base
plate 6. The printed board 4 and the face board 5 are fixed
to the base plate 6 for example by means of screws. The face
board 5 consists of insulating material and is provided with
apertures which are in alignment with the respective female
sockets 7 (Fig. 9) on the printed board 4.

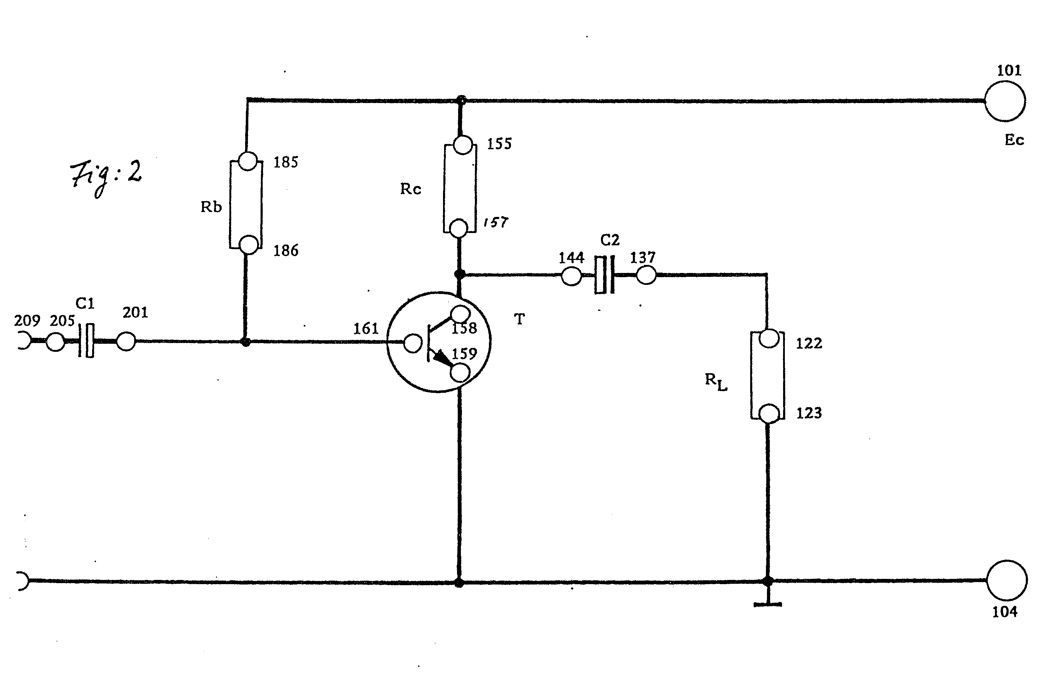

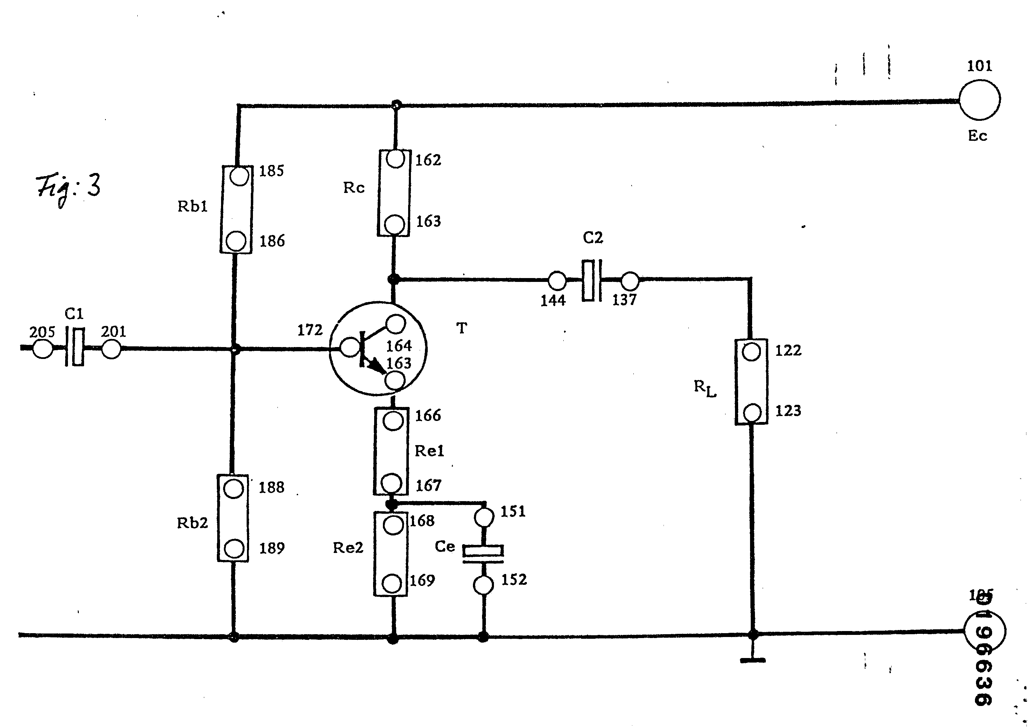

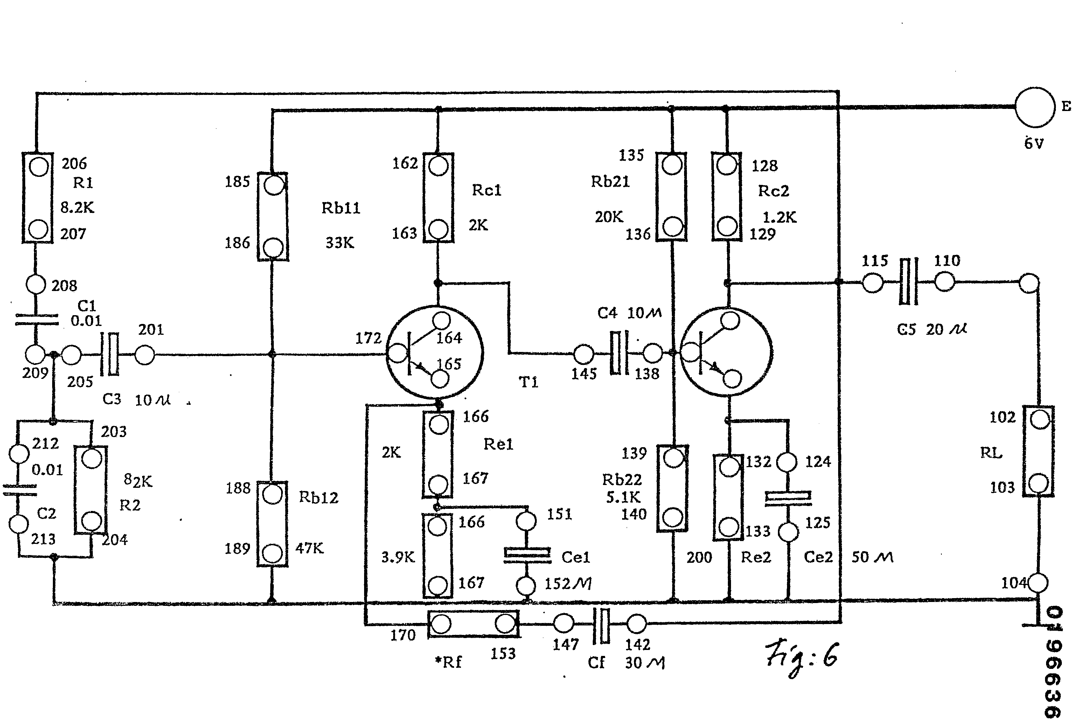

The printed board 4 as used in the jack panel 1 is shown in
Fig. 8. In order to make the printed board 4 to be adapted
for the common use for various circuits as printed on the
circuit-cards 3, and in order to eliminate the possibility
of interference of the experimental circuits with each other,
and, furthermore, to ensure the mutual independence as well
as the possibility to understand the circuit diagrams clearly and to design the circuit diagrams with intuition, the
arrangement of the apertures of the printed board 4 must be
designed in a systematical step-by-step way instead of a
matrix-array design. By designing the conductive paths on the
printed board 4 in the above way, a larger number of components may be accomodated on the jack panel 1 while the space
needed by the experimental circuits is kept at a minimum. The
system of designing the conductive paths on the printed board
is now explained by way of example with reference to Figs. 2,
3 and 7. In these figures, Fig. 2 shows a circuit with the
emitter grounded directly, Fig. 3 a circuit with the emitter
grounded through a resistor Re1, Re2, and Fig. 7 an emitter follower with the collector connective to the positive terminal of the power supply. The apertures in the jack panel 1
for the prongs of the transistor units have to be at different
positions for the three circuits. In this way no short-circuit
plugs are needed in the experiments, and each of the above-
mentioned circuits may be accomplished on the common jack
panel 1. Some of the apertures in the jack panel may be used
in common for building up different circuits in order to
reduce the space taken up by the printed board. Therefore, it
is possible to conduct various experiments on one and the
same common jack panel with electrical circuits containing
different components. In particular, different fundamental
circuits as  preamplifiers, power amplifiers, LC and DC sinuidal and non-sinuidal oscillators, rectification circuits and
filter circuits as well as power supply circuits may be embodied. Also a variety of biasing circuits for the active
components of the above-mentioned circuits, any kinds of
couplings between various stages of the above-mentioned circuits as well as components of the same kind having different
values may be used or exchanged in order to find out about
the influence of such changes on the function of the experimental circuit. All the various circuits and modifications
can be built up by means of plug/socket units which are stored
in a box. The components, e.g. resistors, capacitors, diodes
and the like are marked with a conventional colour code.

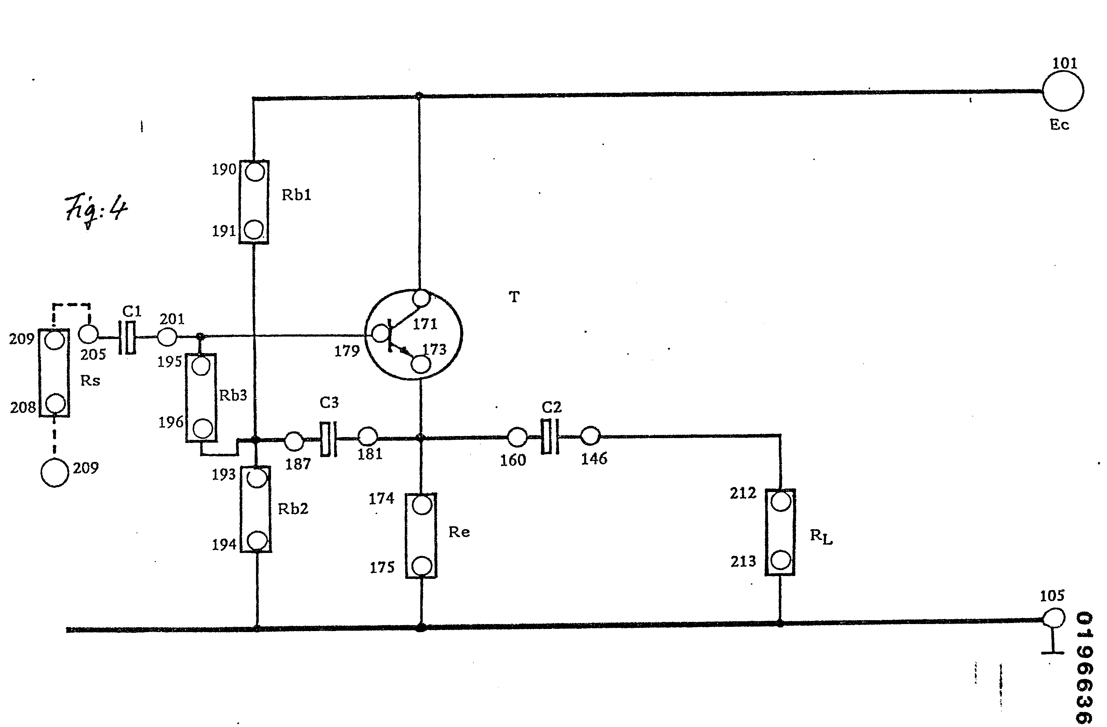

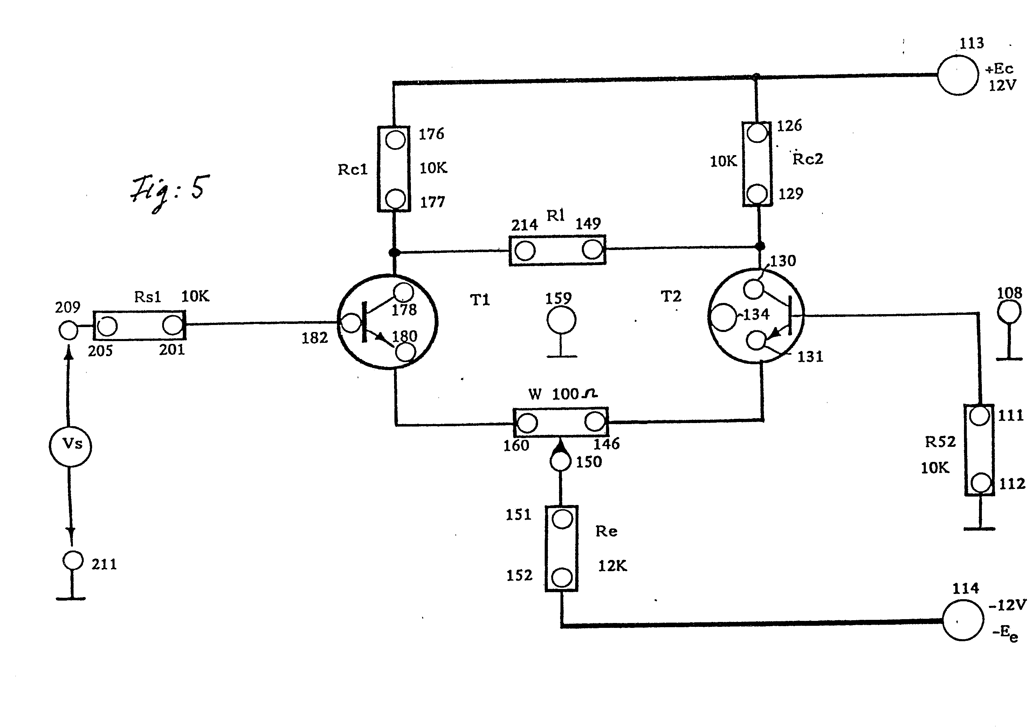

Figs. 2-7 show different circuit-cards on which individual
transistor circuits are printed. The components of the circuits are marked as resistors R, capacitors C, transistors
T, diodes D and the like as usual in the design of electronic circuits. In these figures, also the positions of the
apertures in the face board 5 and the printed board 4 of
the jack panel 1 are marked. The apertures are provided
with numbers which correspond to the numbers shown in Fig. 8
pertaining to the positions where the conductive paths of the printed board 4 are contacted. If, for example, the transistor T (Fig. 2) is plugged into the jack panel 1 in the positiion indicated in Fig. 2, the prongs of this unit make contact with the point 161, 158 and 159 of the printed board 4 as indicated in Fig. 8. The resistors, capacitors and diodes are contained in plug/socket units having two prongs, and the transistors, FETs and solid state potentiometers are contained in plug/socket units having three prongs. The plug/ socket units can also have a larger number of prongs in case integrated circuits or the like are built into the units. For example, a plug/socket unit containing an operational amplifier would have an elongated or cylindrical form and contain eight prongs for making the necessary connection to the operational amplifier.

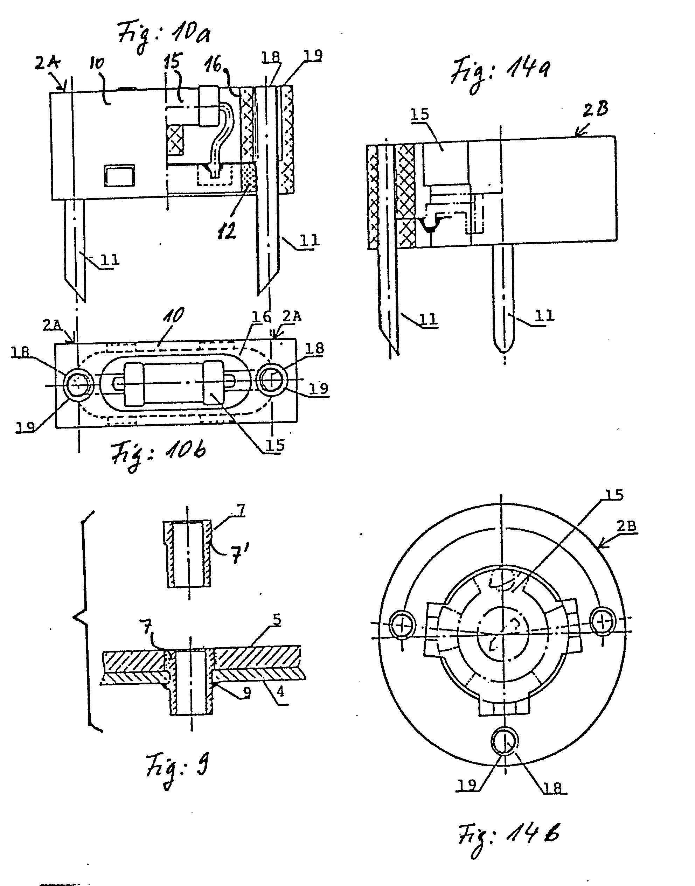

In the following specification the details of the plug/socket units are explained. As can be seen in Fig. 9, the female sockets 7 are riveted on the printed board 4 with copper rivets. Furthermore, the female sockets 7 are connected to the conductive circuit paths of the printed board 4 by soldering. To ensure a sufficient mechanical strength of the female sockets 7 and a good contact between the prongs 11 (Fig. 12a) of the plug/socket units and the sockets 7, the sockets 7 have a shoulder 7' which rests - in the assembled state - on the printed board 4.

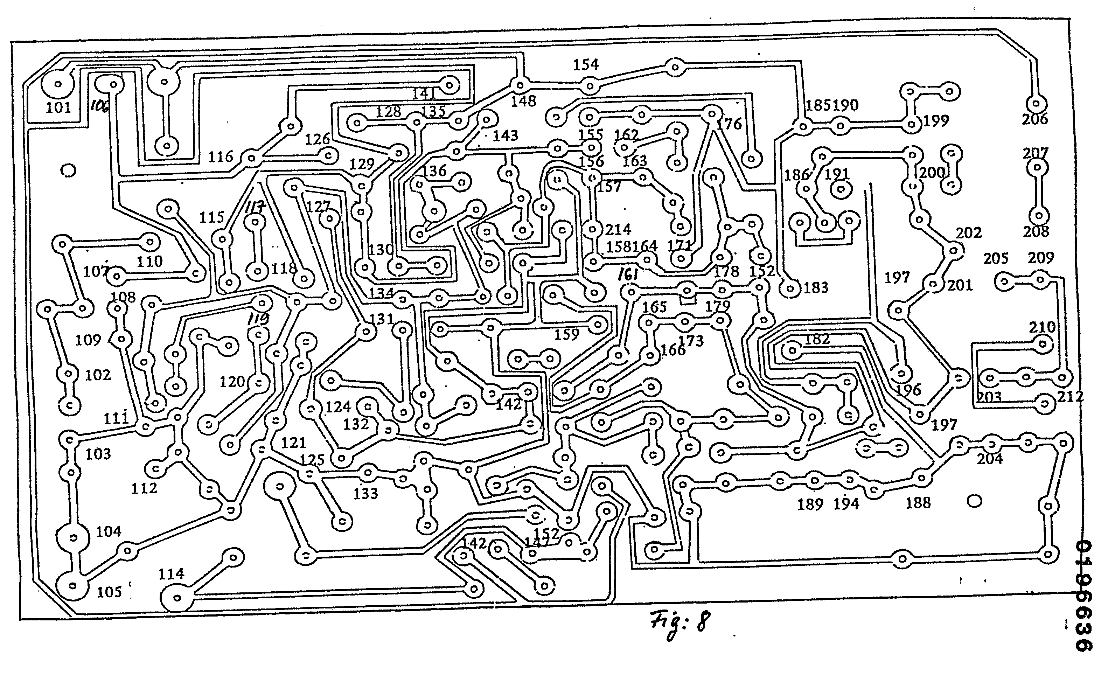

Fig.10a shows an embodiment of a plug/socket unit 2A comprising a plastic body 10, a pair of hollow prongs 11 as well as an electrical component 15 (resistor) which is contained in a recess 16 of the plastic body 10. Since the recess 16 is open to the top of the plastic body 10, the component 15 may be readily seen from the outside so that the nature of the plug/socket unit may be readily identified. The prongs 11 are seated in a throughhole 19 of the plastic body 10. The upper end (as seen in Fig. 10a) of the hollow prong 11 forms a concentric socket 18 for receiving further plugs for making parallel connections, extensions or are serving as testing points.

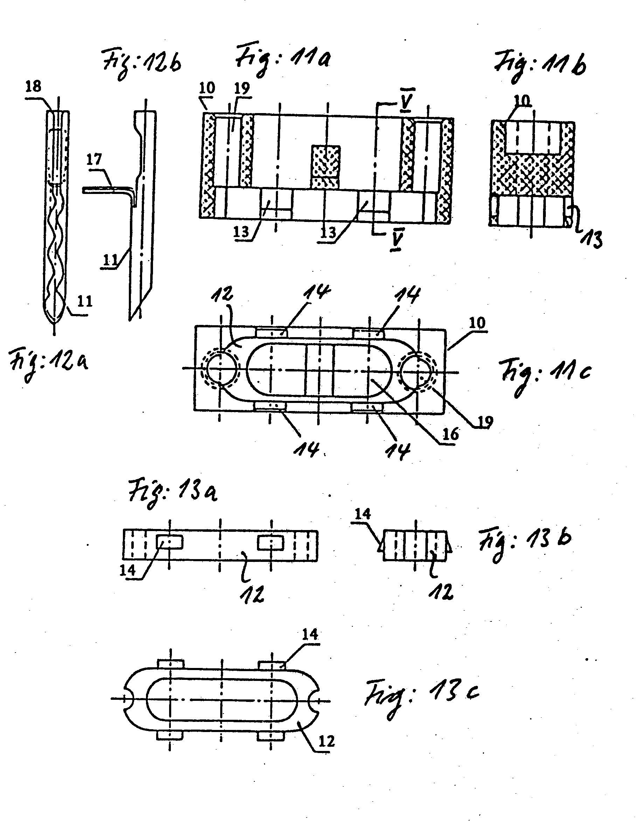

Figs. 11 to 13 show the parts of the plug/socket unit of Fig.
10. Fig. 11a shows a section of the plastic body 10. Prongs
11 as shown in Figs. 12a and 12b may be inserted into the
throughhole 19 of the plastic body 10 of Fig. 11a. The hollow
prongs 11 are formed by a pressing process out of sheet material having an appropriate rigidity, for example bronze
sheet material. The sheet material is bent to form a cylindrical body of the prong 11, the seam of the sheet material
having a zig-zag-form (Fig. 12a). A tongue 17 is punched and
bent outward from the wall of the hollow prong 11, which
tongue serves for making a soldering connection with the lead
to the component as seen in Fig. 10a.

In the plug/socket unit (Fig. 11a) a snap piece 12 is secured
to the plastic body 10 by means of locking tabs 14 engaging
corresponding locking holes 13 of the plastic body 10, as
the snap piece 12 is snap-fitted into the plastic body 10.

In order to facilitate the insertion of the prongs 11 into
the holes of the jack panel and also to hold the prongs 11
in place in the inserted position, the upper end of the holes
19 in the plastic body 10 have a somewhat larger diameter
than the outer diameter of the prongs 11 so that the prongs
11 have a loose fitting in the upper portion of the holes 19.
The point where the leads to the component 15 are soldered
to the tongues 17 of the prongs 11 may have a slightly longer
distance than shown in Fig. 10a. Then, an elastic force is
created which, together with the action of the close-fitted
lower end of the throughholes 19 and the plastic snap piece
12, presses against the prong 11. In this way the prongs 11
are easily to be inserted or detached to the jack panel, and
the prongs 11 also are held securely in the plug/socket units.

Claims

1. A teaching and demonstrating apparatus for electrical circuits comprising plug/socket units and circuit-cards and being used as a demonstation apparatus for teaching and trai-
ning purposes, c h a r a c t e r i z e d  by:
(a) a set of circuit-cards (3) each of said circuit cards (3)
    having an experimental circuit diagram and all the components symbols printed on it as well as apertures permitting plugging-in and out of the plug/socket units,
(b) a set of plug/socket units (2) containing circuit components, and
(c) a common jack panel (1) comprising a printed board (4)
    on which a variety of circuit connections in the form of
    conductive paths are printed and in which printed board
    (4) are also arranged apertures in alignment with the
    apertures in the circuit-cards (3) of the set of circuit-
    cards, whereby
an electric circuit may be accomplished by putting a circuit-
card (3) on the jack panel (1) and plugging all the plug/
socket units into the jack panel (1) which units are printed
on the circuit-card.

2. An apparatus as claimed in claim 1, c h a r a c t e r i -
z e d  in that the plug/socket unit (2) comprises a plastic
body (10) as well as receiving means for prongs (11) and a
plastic snap piece (12) securing the prongs (11) in the plastic body (10).

3. An apparatus according to claim 2, c h a r a c t e r i -
z e d  in that the prongs (11) are hollow press-formed pieces.

4. An apparatus according to claim 2, c h a r a c t e r i -
z e d  in that the plastic snap piece (12) comprises locking tabs (14) which are snap-fitted in corresponding locking holes (13) provided in the plastic body (10).

5. An apparatus according to claim 2, c h a r a c t e r i -
z e d   in that the plastic bodys have recesses (16) open to the top so that the components contained in the plastic body (10) may be identified from outside.

6. An apparatus according to claim 3, c h a r a c t e r i -
z e d   in that the prongs (11) are provided with tongues (17) to which the leads of the components (15) contained in the plug/socket unit are soldered.

7. An apparatus according to claim 2, c h a r a c t e r i -
z e d   in that the securing means for the prongs (11) in the plastic body (10) comprise throughholes (19) in the plastic body (10), the upper end of said throughhole (19) having a slightly larger diameter than the diameter of the prong (11) while the lower end of said throughhole (19) forms a close fit with the prong (11), whereby the prongs (11) are secured in the plastic body (10) by means of the plastic snap piece (12).

8. An apparatus according to claim 1, c h a r a c t e r i -
z e d   by female sockets (7) secured to at least the printed board (4) and being soldered to one of the conductive paths on the printed board (4).

9. An apparatus according to claim 8, c h a r a c t e r i -
z e d   in that the female socket (7) is riveted to the printed board (4), preferrably by a copper rivet, and has a shoulder (7') supported on the printed board (4) in the assembled state.

Fig: 1a

2B   2A   2A   3

5

8

4

7

6

Fig: 1b

1

Fig:2

Fig. 3

0196636

Fig. 4

4/10

0196636

Fig: 5

Fig:6

Fig. 7

Fig. 8

Fig: 10a

Fig: 14a

Fig: 106

Fig: 9

Fig: 14b

Fig: 12b

Fig: 11a

Fig: 11b

18

17

11

11

11

Fig: 12a

10 19

$\overline{V}$

13 13

$\overline{V}$

10

13

12 14 14

10

14 14

16 19

Fig: 11c

Fig: 13a

14

12

14

12

Fig: 13b

14

Fig: 13c

12